# EUROPEAN PATENT APPLICATION

(11) **EP 4 790 348 A1**
(43) Date of publication of application: **12.08.2026**
(21) Application number: 25221827.6
(22) Date of filing: 09.12.2025
(51) Int. Cl.: F28D 15/02, F28D 15/04, F28F 1/32

(54) **DUAL-SYSTEM COOLING APPARATUS**

(30) Priority: 10.02.2025 CN 202510147135
(71) Applicant: Purple Cloud Development Pte. Ltd., Singapore 128424 (SG)
(72) Inventor: LIU, LEI LEI, Hui Zhou City (CN); LIN, HUA-YUAN, 114065 Taipei City (TW); KE, SHAO-HSUAN, 114065 Taipei City (TW)
(74) Representative: Grünecker Patent- und Rechtsanwälte PartG mbB

(57) **Abstract**

A dual-system cooling apparatus includes a first cooling system having a first enclosure that encloses a first cavity and a second cooling system having a second enclosure that encloses a second cavity and has a capillary structure on an inner surface of the second enclosure. The first enclosure is positioned over the second enclosure. A first working fluid of the first cooling system is different from a second working fluid of the second cooling system.

## Description

### TECHNICAL FIELD

The present disclosure relates to a cooling apparatus, in particular to a dual-system cooling apparatus.

### BACKGROUND

During the operation of electronic devices, the heat generated by the processor needs to be quickly removed to keep the operating temperature within the range recommended by its manufacturer. Currently, it is a common method to remove the heat generated by the processor in the electronic device through a vapor chamber.

### SUMMARY

The present disclosure provides a dual-system cooling apparatus with improved heat dissipation performance to meet the heat dissipation requirements of electronic devices that generate high power heat.

The invention is as defined in the appended claims. Aspects of the disclosure provide a dual-system cooling apparatus. The dual-system cooling apparatus can include a first cooling system having a first enclosure that encloses a first cavity, and a second cooling system having a second enclosure that encloses a second cavity and has a capillary structure on an inner surface of the second enclosure. The first enclosure is positioned over the second enclosure, and a first working fluid of the first cooling system is different from a second working fluid of the second cooling system.

In an embodiment, a first freezing point of the first working fluid of the first cooling system is lower than a second freezing point of the second working fluid of the second cooling system. In an embodiment, the second cooling system is a vapor chamber cooling device, and the first cooling system includes a capillary-structure-based heat pipe, a thermosiphon, or a pulsating heat pipe. In an embodiment, the second cooling system is a vapor chamber cooling device that includes a vapor chamber formed by a first plate and a second plate opposing the first plate and a first column structure and a second column structure within the vapor chamber. The first column structure and the second column structure extend from the first plate to the second plate. The first column structure is positioned at a heat source area of the vapor chamber. The second column structure is positioned outside the heat source area. The first column structure has a larger cross-sectional area than the second column structure.

In an embodiment, the second cooling system is a vapor chamber cooling device having a vapor chamber formed by two opposing plates, and the first cooling system is a loop heat pipe with a closed-loop channel. A section of the loop heat pipe is in contact with one of the two opposing plates. The section of the loop heat pipe passes through the vapor chamber. The loop heat pipe includes a capillary-structure-based heat pipe, a thermosiphon, or a pulsating heat pipe.

In an embodiment, the second cooling system is a vapor chamber cooling device having a vapor chamber formed by two opposing plates. The first cooling system includes a chamber positioned in contact with one of the two opposing plates and having two openings in a sidewall of the chamber, and a heat pipe having two open ends in connection with the chamber via the two openings.

In an embodiment, the second cooling system is a vapor chamber cooling device having a vapor chamber formed by two opposing plates, and the first cooling system includes a first chamber positioned over a second chamber that is positioned on one of the two opposing plates, a first heat pipe having a first open end and a second open end, and a second heat pipe having a third open end and a fourth open end. The first open end and the third open end are fluidly connected with the first chamber, and the second open end and the fourth open end are fluidly connected with the second chamber. The first heat pipe or the second heat pipe includes a capillary-structure-based heat pipe, a thermosiphon, or a pulsating heat pipe.

In an embodiment, the first cooling system is a first vapor chamber cooling device having a first vapor chamber, and the second cooling system is a second vapor chamber cooling device having a second vapor chamber. The first vapor chamber is positioned over the second vapor chamber, and the second vapor chamber cooling device has a heat pipe protruding from the second vapor chamber and extends through the first vapor chamber positioned over the second vapor chamber.

In an embodiment, the first cooling system includes a first vapor chamber and a first heat pipe with two open ends connected to two opposing sidewalls of the first vapor chamber, and the second cooling system is a vapor chamber cooling device that includes a second vapor chamber and a second heat pipe protruding from the second vapor chamber. The second heat pipe has a closed end and an open end connecting to the second vapor chamber. The first vapor chamber is positioned in contact with the second vapor chamber, and the first heat pipe and the second heat pipe extend through a fin structure. In an example, the first heat pipe includes a capillary-structure-based heat pipe, a thermosiphon, or a pulsating heat pipe.

In an embodiment, the second cooling system is a vapor chamber cooling system having a vapor chamber, and the first cooling system is a loop heat pipe with a closed-loop channel that includes a first portion and a second portion. The first portion including a sequence of similarly-structured sections connected sequentially, each such section having a first sub-section contained in the vapor chamber and a second sub-section formed outside the vapor chamber. The second sub-section having a first open end connecting to the first sub-section of the same similarly-structured section and a second open end connecting to the first sub-section of the neighboring similarly-structured section. The second portion is formed outside the vapor chamber. The second portion connects first end of the first portion to a second end of the first portion. The first sub-sections of the sequence of similarly-structured sections are arranged in parallel with each other in the vapor chamber. The loop heat pipe includes a capillary-structure-based heat pipe, a thermosiphon, or a pulsating heat pipe.

Aspects of the disclosure further provide a three-dimensional vapor chamber cooling apparatus. The three-dimensional vapor chamber cooling apparatus includes a vapor chamber formed by a first plate and a second plate opposing the first plate, the vapor chamber including a heat source area on an inner surface of the second plate, a first heat pipe protruding from and on top of the first plate, the first heat pipe having a closed end and an open end connecting to the vapor chamber at a first portion of the first plate that opposes an area on the inner surface of the second plate outside the heat source area, and a second heat pipe formed outside of the vapor chamber and having two open ends connecting to the vapor chamber through the first plate at a second portion of the first plate opposing the heat source area on the inner surface of the second plate.

In an embodiment, the second heat pipe includes a capillary-structure-based heat pipe, a thermosiphon, or a pulsating heat pipe. In an embodiment, the three-dimensional vapor chamber cooling apparatus further includes a first column structure and a second column structure within the vapor chamber. The first column structure and the second column structure extend from the first plate to the second plate opposing the first plate. The first column structure is positioned at the heat source area. The second column structure is positioned outside the heat source area. The first column structure has a larger cross-sectional area than the second column structure.

Another dual-system cooling apparatus disclosed in an embodiment of the present disclosure is used for thermal contact with a heat source and includes two cooling systems: a vapor chamber cooling device and a loop radiator. In an example, the vapor chamber cooling device is a three-dimensional vapor chamber cooling device that includes a vapor chamber and at least one heat pipe. The vapor chamber has two opposing plates enclosing a cavity and is used for thermally contacting a heat source. The at least one heat pipe is positioned on the vapor chamber. The loop radiator is thermally coupled to the vapor chamber. In an example, the vapor chamber cooling device is not configured with any heat pipes.

Another embodiment of the present disclosure discloses a dual-system cooling apparatus for thermally contacting a heat source, and includes a first heat-conducting plate, a second heat-conducting plate, a third heat-conducting plate, and a heat pipe. The first heat-conducting plate is used for thermal contact with the heat source. The second heat-conducting plate is stacked on the first heat-conducting plate, and together with the first heat-conducting plate, encloses a first vapor chamber. The third heat-conducting plate is stacked on the second heat-conducting plate, and together with the second heat-conducting plate, encloses a second vapor chamber. The second vapor chamber is not fluidly connected to the first vapor chamber. The heat pipe passes through the third heat-conducting plate and communicates with the second vapor chamber.

Another embodiment of the present disclosure discloses a dual-system cooling apparatus for thermally contacting a heat source, and includes a vapor chamber, a heat-absorbing cavity, and a loop heat pipe. The vapor chamber has two opposing plates enclosing a cavity. The heat-absorbing cavity is thermally coupled to one side of the vapor chamber and is used for thermal contact with the heat source. The loop heat pipe passes through the vapor chamber and, in one example, is connected with the vapor chamber.

In the embodiments disclosed herein, since the dual-system cooling apparatus is a combination of a vapor chamber cooling device and either a loop radiator or a second vapor chamber cooling device, the dual-system cooling apparatus can further dissipate heat from the heat source through the thermal function of the additional cooling system, thereby improving the heat dissipation performance to meet the heat dissipation requirements of high-power heat sources. In this way, excessive evaporation of the cooling fluid in the dual-system cooling apparatus that would cause dry burning can be avoided, thereby extending the service life of the dual-system cooling apparatus.

### BRIEF DESCRIPTION OF THE DRAWINGS

Various embodiments of this disclosure that are proposed as examples will be described in detail with reference to the following figures, wherein like numerals reference like elements, and wherein:
FIG. 1 is a perspective view of a dual-system cooling apparatus according to a first embodiment of the present disclosure.
FIG. 2 is an exploded view of the dual-system cooling apparatus of FIG. 1.
FIG. 3 is a schematic cross-sectional view of the dual-system cooling apparatus of FIG. 1.
FIG. 4 is a cross-sectional view of the flow of the cooling fluids in the dual-system cooling apparatus of FIG. 1.
FIG. 5 is a perspective view of a dual-system cooling apparatus according to a second embodiment of the present disclosure.
FIG. 6 is an exploded view of the dual-system cooling apparatus of FIG. 5.
FIG. 7 is a schematic cross-sectional view of the dual-system cooling apparatus of FIG. 5.
FIG. 8 is a perspective view of a dual-system cooling apparatus according to a third embodiment of the present disclosure.
FIG. 9 is an exploded view of the dual-system cooling apparatus of FIG. 8.
FIG. 10 is a schematic cross-sectional view of the dual-system cooling apparatus of FIG. 8.
FIG. 11 is a perspective view of a dual-system cooling apparatus according to a fourth embodiment of the present disclosure.
FIG. 12 is an exploded view of the dual-system cooling apparatus of FIG. 11.
FIG. 13 is a schematic cross-sectional view of the dual-system cooling apparatus of FIG. 11.
FIG. 14 is a perspective view of a dual-system cooling apparatus according to a fifth embodiment of the present disclosure.
FIG. 15 is an exploded view of the dual-system cooling apparatus of FIG. 14.
FIG. 16 is a schematic cross-sectional view of the dual-system cooling apparatus of FIG. 15.
FIG. 17 is a perspective view of a dual-system cooling apparatus according to a sixth embodiment of the present disclosure.
FIG. 18 is an exploded view of the dual-system cooling apparatus of FIG. 17.
FIG. 19 is a schematic cross-sectional view of the dual-system cooling apparatus of FIG. 17.
FIG. 20 is a cross-sectional view of the flow of the cooling fluids in the dual-system cooling apparatus shown in FIG. 17.

### DETAILED DESCRIPTION OF EMBODIMENTS

Generally, a vapor chamber cooling device includes a vapor chamber and a capillary structure. The vapor chamber has a cavity for filling with a working fluid. The capillary structure is arranged in the vapor chamber. The heated area of the vapor chamber is called an evaporation zone. The area of the vapor chamber that dissipates heat is called the condensation zone. The liquid working fluid absorbs heat in the evaporation zone and vaporizes. The vaporized working fluid, e.g., gaseous cooling fluid, releases heat in the condensation zone and condenses into liquid working fluid. Then, the liquid working fluid returns to the evaporation zone through the capillary structure, thus forming a heat dissipation cycle.

As technology advances, the operating performance of electronic devices is also improving, resulting in increasing heat power generated during the operation of electronic devices. However, the heat dissipation performance of current vapor chambers is still insufficient. When the heat power generated by the electronic device during operation is too high, the cooling fluid in the vapor chamber may evaporate excessively and cause dry-burning, thereby damaging the electronic device as well as the vapor chamber. How to improve the heat dissipation performance of the vapor chamber to meet the heat dissipation requirements of electronic devices with high heat power is one of the problems to be solved.

The embodiments disclosed herein describe a dual-system cooling apparatus comprising two distinct cooling systems (such as a vapor chamber cooling device paired with either a loop radiator or a second vapor chamber cooling device). This configuration enhances heat dissipation performance compared to single-system solutions. By distributing thermal load across dual systems, the risk of excessive cooling fluid evaporation that leads to dry burning is mitigated, thereby extending the operational lifespan of the cooling apparatus.

Furthermore, the two cooling systems can be designed to utilize working fluids with varying operational temperature ranges. This complementary configuration expands the effective operational temperature range of the dual-system cooling apparatus beyond what would be achievable with a single working fluid, enabling robust performance across diverse thermal conditions.

Additionally, the dual-system cooling apparatus can incorporate two working fluids with different freezing points, addressing the start-up limitations encountered in sub-zero environments when using water as a working fluid. For example, methanol has a freezing point of approximately -97.6°C. In environments where ambient temperature falls below water's freezing point, the methanol-configured first cooling system can initiate operation and heat the water-configured second cooling system to above 0°C, enabling full system functionality. In various embodiments, either one of the two working fluids can have a freezing point higher or lower than the other one of the two working fluids.

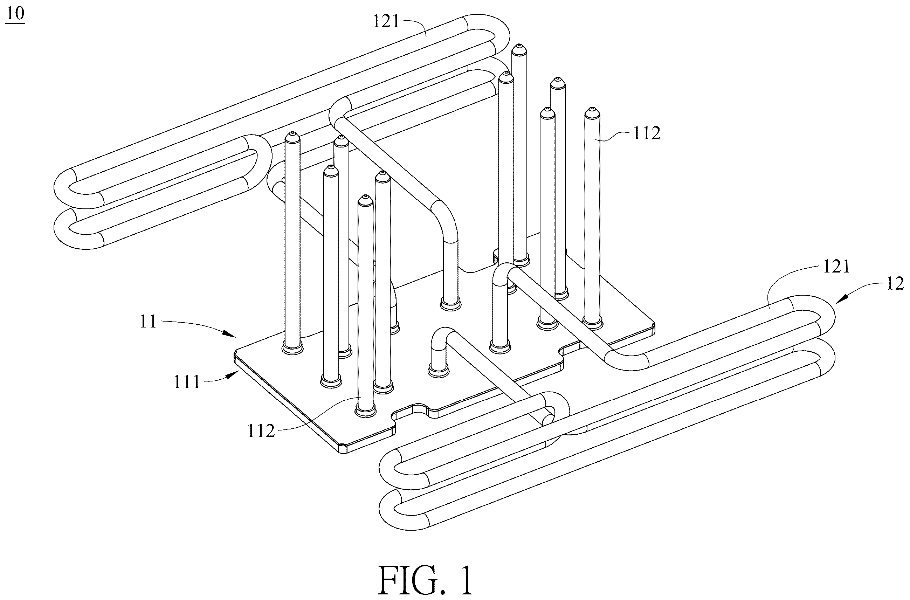

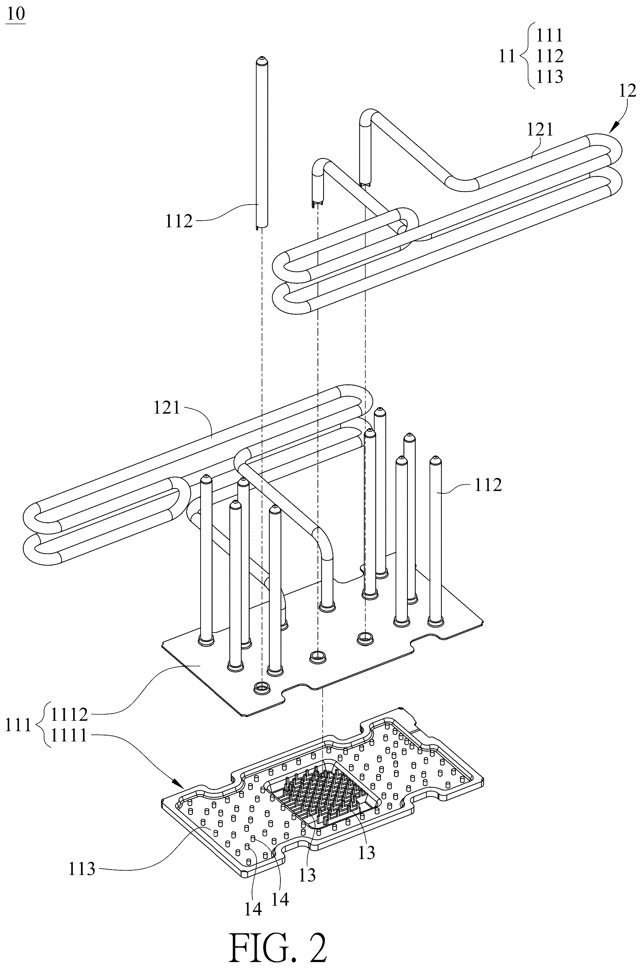

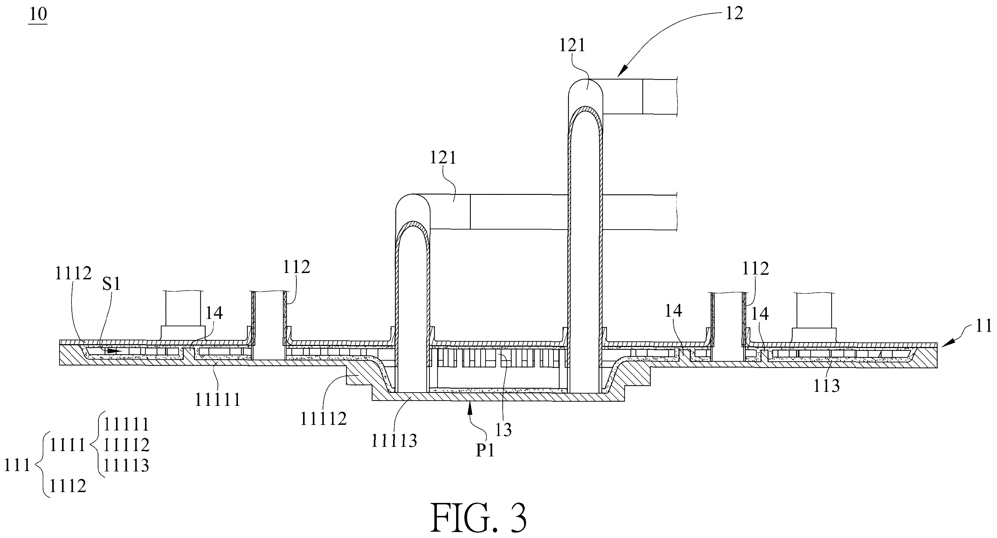

FIG. 1 is a perspective view of a dual-system cooling apparatus according to a first embodiment of the present disclosure. FIG. 2 is an exploded view of the dual-system cooling apparatus of FIG. 1. FIG. 3 is a schematic cross-sectional view of the dual-system cooling apparatus of FIG. 1.

The dual-system cooling apparatus 10 of this embodiment is configured for thermal contact with a heat source (not shown), and includes two cooling systems: a three-dimensional vapor chamber cooling device 11 and a loop radiator 12. The three-dimensional vapor chamber cooling device 11 includes a vapor chamber 111, a plurality of heat pipes 112, and a capillary structure 113.

The vapor chamber 111 includes a first heat-conducting plate 1111 and a second heat-conducting plate 1112. The first heat-conducting plate 1111 is configured to thermally contact a heat source. The second heat-conducting plate 1112 is positioned on the first heat-conducting plate 1111, such that the second heat-conducting plate 1112 and the first heat-conducting plate 1111 together form an enclosure enclosing a cavity S1. The cavity S1 contains a cooling fluid (not shown).

The first heat-conducting plate 1111 includes a bottom plate 11111, a first convex structure 11112 and a second convex structure 11113. The first convex structure 11112 protrudes from the bottom plate 11111 towards a direction away from the second heat-conducting plate 1112. The second convex structure 11113 has a thermal contact surface P1. The thermal contact surface P1 is in thermal contact with the heat source, allowing the heat of the heat source to transfer to the cooling fluid through the thermal contact surface P1. The second convex structure 11113 protrudes from the first convex structure 11112 toward a direction away from the second heat-conducting plate 1112.

The heat pipes 112 are connected to the second heat-conducting plate 1112 and communicate with the cavity S1. When the liquid cooling fluid absorbs the heat from the heat source and vaporizes, it flows from the cavity S1 into the heat pipes 112. The capillary structure 113 is positioned within the vapor chamber 111. By including the capillary structure 113, the vaporized cooling fluid, e.g. gaseous cooling fluid, can release the heat of the heat source and condense, and then flow back through the capillary structure 113 from the heat pipes 112 into the cavity S1.

The loop radiator 12 includes a plurality of loop heat pipes 121. The loop radiator 12 is, for example, a pulsating radiator, and the loop heat pipe 121 is, for example, a pulsating heat pipe (PHP). The so-called pulsating heat pipe includes a plurality of U-shaped tubes connected in series where no capillary structure is provided inside the pulsating heat pipe. Thus, the heat source can be further dissipated through the thermosyphon effect of the pulsating heat pipe, thereby improving the heat dissipation efficiency.

In this embodiment, the loop radiator 12 is a pulsating radiator, and the loop heat pipe 121 is a pulsating heat pipe, but the present disclosure is not limited thereto. In other embodiments, the loop radiator 12 may be, for example, a thermosiphon radiator, and the loop heat pipes 121 may be, for example, thermosiphon heat pipes. In some embodiments, the loop heat pipes 121 may be capillary-structure-based heat pipes.

In some examples, a thermosiphon heat pipe includes a capillary structure along the entire inner surface. The liquid cooling fluid partially vaporizes to form a gas-liquid mixture after being heated, and the liquid cooling fluid and the gaseous cooling fluid are randomly distributed within the pipeline of the loop heat pipe through the capillary forces of the capillary structure. In some examples, the density difference between the liquid cooling fluid and the gaseous cooling fluid drives the heat dissipation cycle. In some examples, the liquid cooling fluid partially evaporates into gaseous cooling fluid after being heated. The vapor pressure of the gaseous cooling fluid serves as the driving force, pushing the liquid cooling fluid to facilitate the heat dissipation cycle.

The opposite ends of the loop heat pipe 121 are fluidly connected to the cavity S1 of the vapor chamber 111. The cooling fluid can circulate through the vapor chamber 111 and the loop heat pipes 121 to perform heat dissipation circulation for the heat source. Open ends of the loop heat pipe 121 are positioned at a portion of the second heat-conducting plate 1112 opposing a heat source area on the inner surface of the first heat-conducting plate 1111. The heat source area corresponds to the contact surface P1. Open ends of the heat pipes 112 are positioned at a portion of the second heat-conducting plate 1112 opposing an area outside the heat source area on the inner surface of the first heat-conducting plate 1111.

In this embodiment, since the dual-system cooling apparatus 10 combines a three-dimensional vapor chamber cooling device 11 and a loop radiator 12, the dual-system cooling apparatus 10 enhances heat dissipation efficiency through the thermosyphon effect of the loop radiator 12. Thus, excessive evaporation of the cooling fluid in the dual-system cooling apparatus 10 can be prevented, lowering the risk of dry burning and extending the service life of the dual-system cooling apparatus 10.

In this embodiment, the dual-system cooling apparatus 10 further includes a plurality of main heat-conducting columns 13 and a plurality of auxiliary heat-conducting columns 14. The main heat-conducting columns 13 are positioned in a heat source area in the cavity S1. The heat source area corresponds to the thermal contact surface P1. The auxiliary heat-conducting columns 14 are positioned in an area in the cavity S1 outside the heat source area. The temperature of the main heat-conducting columns 13 is higher than that of the auxiliary heat-conducting columns 14 when the dual-system cooling apparatus is in operation. By including the main heat-conducting columns 13 and the auxiliary heat-conducting columns 14, the heat transfer efficiency can be further enhanced. The cross-sectional area of the main heat-conducting columns 13 is, for example, smaller than that of the auxiliary heat-conducting columns 14.

In this embodiment, the cross-sectional area of the main heat-conducting columns 13 is smaller than that of the auxiliary heat-conducting columns 14, but the present disclosure is not limited thereto. In other embodiments, the diameters or cross-sectional area of the main heat-conducting columns may be greater than or equal to those of the auxiliary heat-conducting columns.

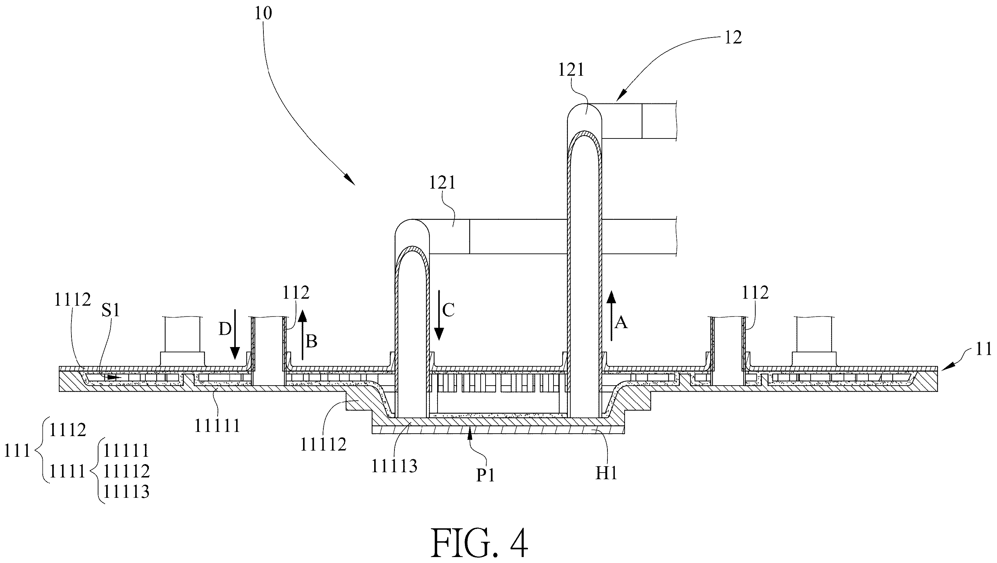

FIG. 4 is a cross-sectional view of the flow of the cooling fluid in the dual-system cooling apparatus in FIG. 1. In an example, when the heat generated by the heat source H1 is transferred to the liquid cooling fluid in the cavity S1 through the first heat-conducting plate 1111, the liquid cooling fluid vaporizes and flows from the cavity S1 into the loop heat pipes 121 and the heat pipes 112 along directions A and B respectively. Subsequently, the gaseous cooling fluid condenses in the loop heat pipes 121 and the heat pipes 112 before flowing back to the cavity S1 along directions C and D respectively. Thus, the heat dissipation cycle of the cooling fluid for the heat source H1 can be completed.

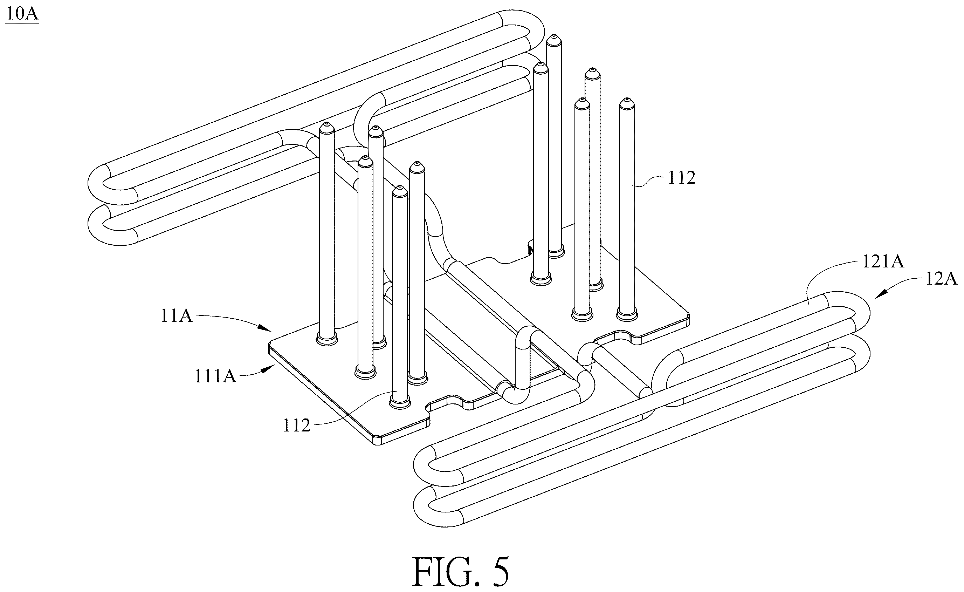

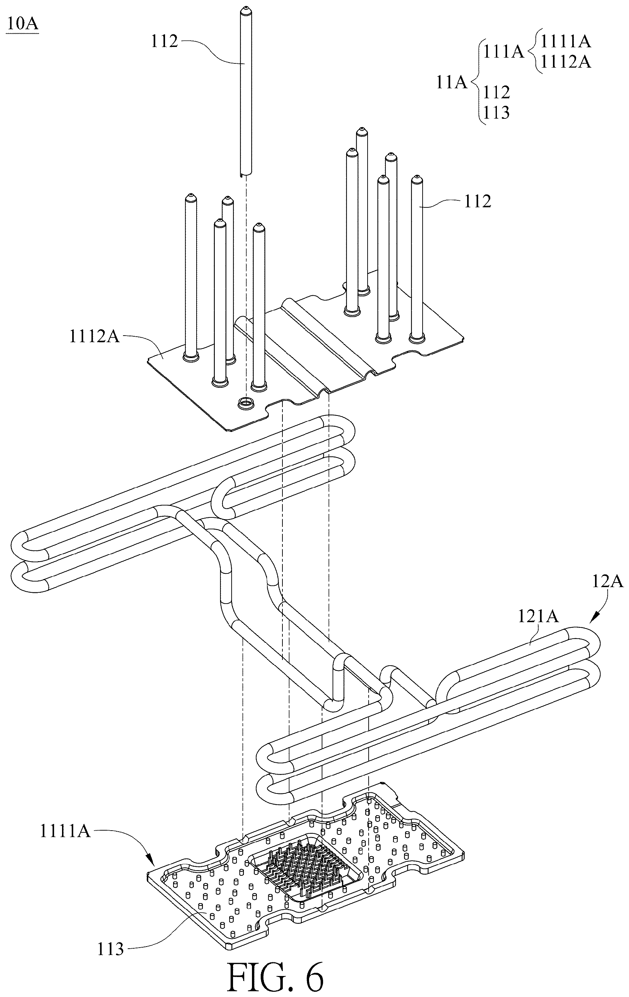

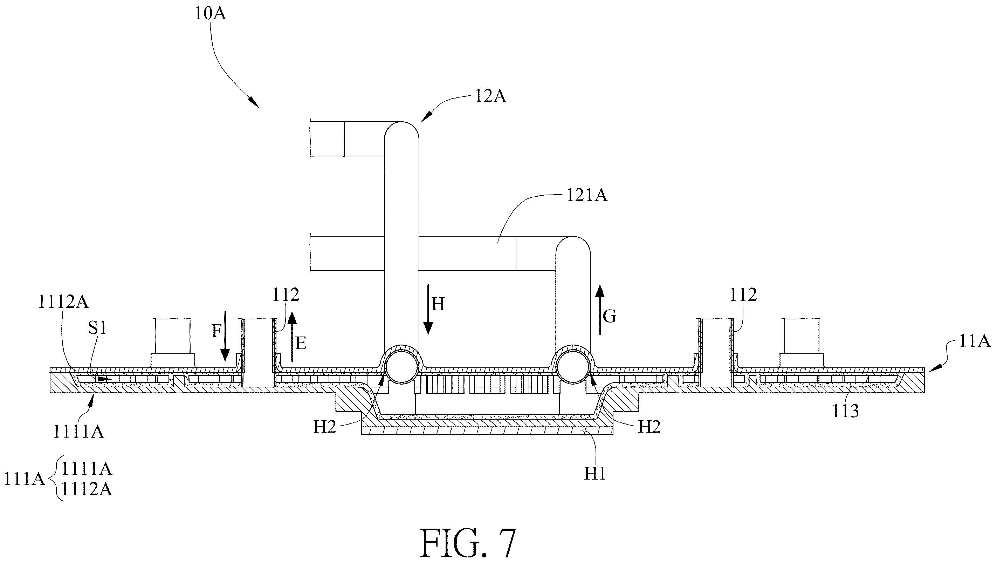

FIG. 5 is a perspective view of a dual-system cooling apparatus according to a second embodiment of the present disclosure. FIG. 6 is an exploded view of the dual-system cooling apparatus of FIG. 5. FIG. 7 is a schematic cross-sectional view of the dual-system cooling apparatus of FIG. 5.

The dual-system cooling apparatus 10A of this embodiment includes components similar to those in the dual-system cooling apparatus 10 of the first embodiment. Therefore, only the differences between this embodiment and the first embodiment will be described below, while the similarities will not be repeated. In this embodiment, the dual-system cooling apparatus 10A includes two cooling systems: a three-dimensional vapor chamber cooling device 11A and a loop radiator 12A. The three-dimensional vapor chamber cooling device 11A includes a vapor chamber 111A and a plurality of heat pipes 112.

The vapor chamber 111A includes a first heat-conducting plate 1111A and a second heat-conducting plate 1112A. The first heat-conducting plate 1111A is configured to be in thermal contact with a heat source. The second heat-conducting plate 1112A is positioned on the first heat-conducting plate 1111A, so that the second heat-conducting plate 1112A and the first heat-conducting plate 1111A together enclose a cavity S1. The cavity S1 contains a first cooling fluid (not shown). The heat pipes 112 are connected to the second heat-conducting plate 1112A and communicate with the cavity S1.

The loop radiator 12A includes a loop heat pipe 121A. The loop heat pipe 121A is, for example, a pulsating heat pipe, but is not limited thereto. In other embodiments, the loop heat pipe may also be, for example, a thermosiphon heat pipe or a capillary-structure-based heat pipe. The loop heat pipe 121A provides an enclosure containing a second cooling fluid (not shown). The freezing point of the first cooling fluid is, for example, higher than the freezing point of the second cooling fluid. The filling ratio of the first cooling fluid in the cavity S1 is, for example, less than the filling ratio of the second cooling fluid in the loop heat pipe 121A.

A plurality of through holes H2 are formed at the junctions where the first heat-conducting plate 1111A and the second heat-conducting plate 1112A join together. A portion of the loop heat pipe 121A is located within the through holes H2. Each through hole H2 accommodates a portion of the loop heat pipe 121A. The loop heat pipe 121A is not fluidly connected to the cavity S1. The loop heat pipe 121A forms a circulation channel (a closed-loop channel) and are thermally coupled to the vapor chamber 111A. Thus, the first cooling fluid and the second cooling fluid remain separate. In this way, the heat dissipation cycle of the first cooling fluid and the heat dissipation cycle of the second cooling fluid do not interfere with each other.

In FIG. 7 example, when the heat generated by the heat source H1 is transferred to the liquid first cooling fluid in the cavity S1 through the first heat-conducting plate 1111A, the first liquid cooling fluid vaporizes and flows into the heat pipes 112 along the direction E from the cavity S1. Subsequently, the gaseous first cooling fluid condenses in the heat pipes 112 and then flows back along the direction F to the cavity S1. In addition, the second cooling fluid in the loop heat pipe 121A is heated and vaporized near the cavity S1, and condensed at a location of the loop heat pipe 121A away from the cavity S1, circulating, for example, along from directions G to H. In this way, the heat dissipation cycle of the cooling fluid for the heat source H1 can be completed.

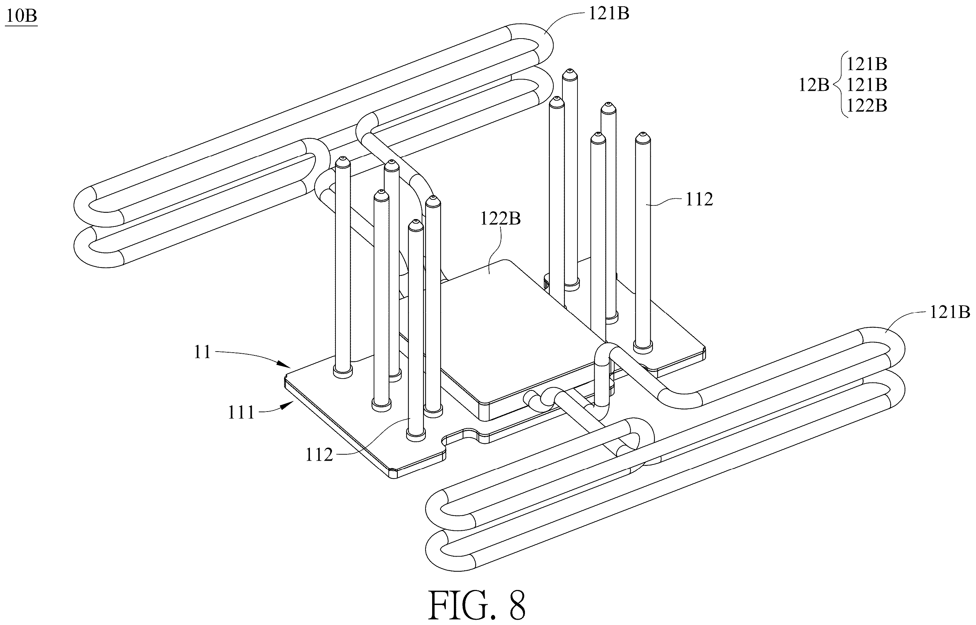

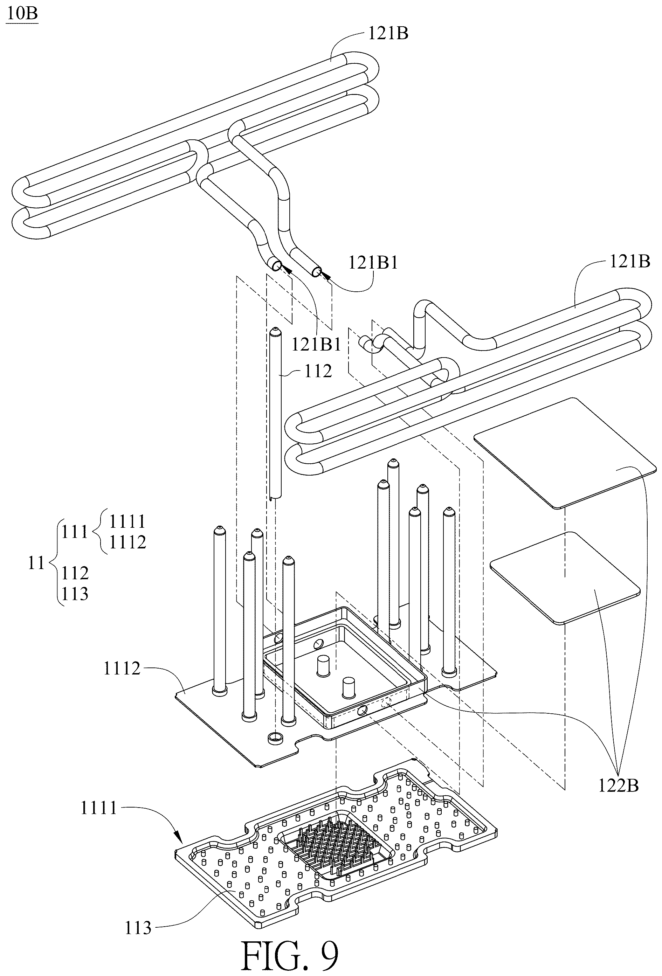

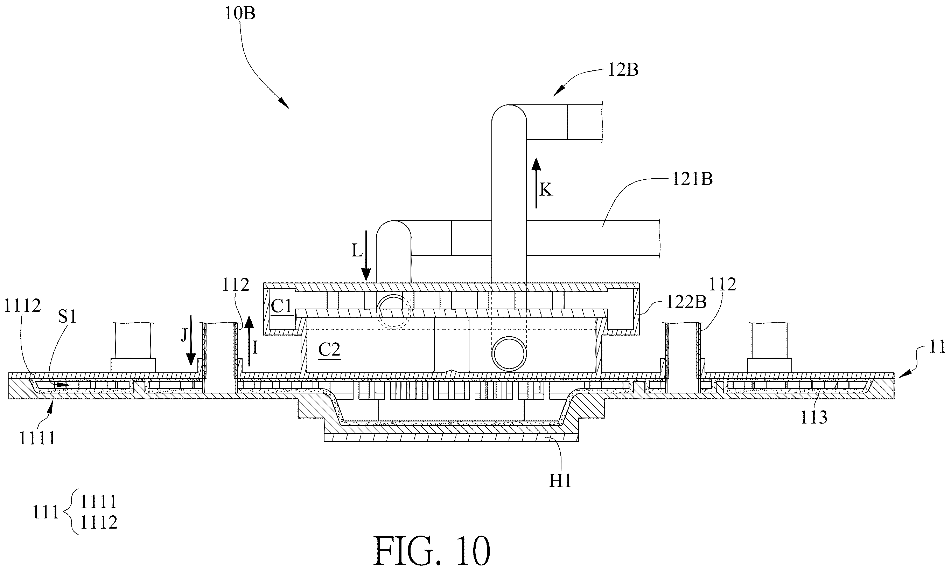

FIG. 8 is a perspective view of a dual-system cooling apparatus according to a third embodiment of the present disclosure. FIG. 9 is an exploded view of the dual-system cooling apparatus of FIG. 8. FIG. 10 is a schematic cross-sectional view of the dual-system cooling apparatus of FIG. 8.

The dual-system cooling apparatus 10B of this embodiment includes components similar to those of the dual-system cooling apparatus 10 of the first embodiment. Therefore, the following will focus on the differences between this embodiment and the first embodiment, and the similarities will not be repeated. In this embodiment, the dual-system cooling apparatus 10B includes two cooling systems: a three-dimensional vapor chamber cooling device 11 and a loop radiator 12B. The three-dimensional vapor chamber cooling device 11 includes a vapor chamber 111 and a plurality of heat pipes 112.

The vapor chamber 111 includes a first heat-conducting plate 1111 and a second heat-conducting plate 1112. The first heat-conducting plate 1111 is configured to thermally contact a heat source. The second heat-conducting plate 1112 is positioned on the first heat-conducting plate 1111, so that the second heat-conducting plate 1112 and the first heat-conducting plate 1111 together enclose a cavity S1. The cavity S1 contains a first cooling fluid (not shown). The heat pipes 112 are connected to the second heat-conducting plate 1112 and communicate with the cavity S1.

The loop radiator 12B provides an enclosure containing a second cooling fluid (not shown), and includes a loop chamber 122B and a plurality of loop heat pipes 121B. The loop chamber 122B is thermally coupled to the second heat-conducting plate 1112. These loop heat pipes 121B are, for example, pulsating heat pipes, thermosiphons, or capillary-structure-based heat pipes. The freezing point of the first cooling fluid is, for example, higher than the freezing point of the second cooling fluid. The filling ratio of the first cooling fluid in the cavity S1 is, for example, less than the filling ratio of the second cooling fluid in the loop heat pipes 121B.

Each of these loop heat pipes 121B has two open ends 121B1. The two open ends 121B1 are both connected to the loop chamber 122B via openings on sidewalls of the loop chamber 122B. The second cooling fluid can circulate in the loop chamber 122B and the loop heat pipes 121B through the two open ends 121B1 to perform heat dissipation circulation.

In an example, the loop chamber 122B includes a first chamber C1 and a second chamber C2. The first Chamber C1 is stacked over the second chamber C2. The second Chamber C2 is positioned over the vapor chamber 111. A first heat pipe of the heat pipes 121B has a first open end and a second open end. A second heat pipe of the heat pipes 121B has a third open end and a fourth open end. The first open end and the third open end are fluidly connected with the first chamber C1. The second open end and the fourth open end are fluidly connected with the second chamber C2.

In FIG. 10 example, when the heat generated by the heat source H1 is transferred to the liquid cooling fluid in the cavity S1 through the first heat-conducting plate 1111, the first cooling fluid vaporizes and flows from the cavity S1 along the direction I into the heat pipes 112. Next, the gaseous first cooling fluid condenses in the heat pipes 112 before flowing back to the cavity S1 along direction J. In addition, the second cooling fluid in the loop radiator 12B will be vaporized after being heated in the loop chamber 122B, and will flow into the loop heat pipes 121B along the direction K from the loop chamber 122B. Then, the gaseous second cooling fluid condenses in the loop heat pipes 121B and flows back along the direction L to the loop chamber 122B. In this way, the heat dissipation cycle of the cooling fluid for the heat source H1 can be completed.

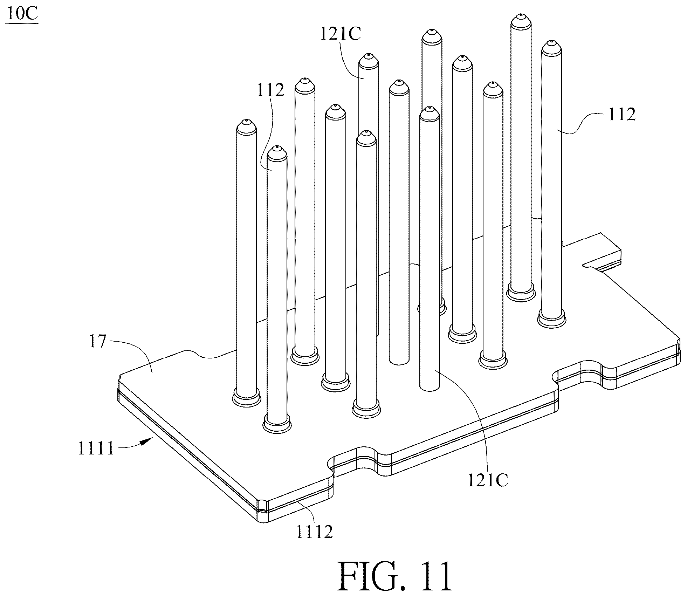

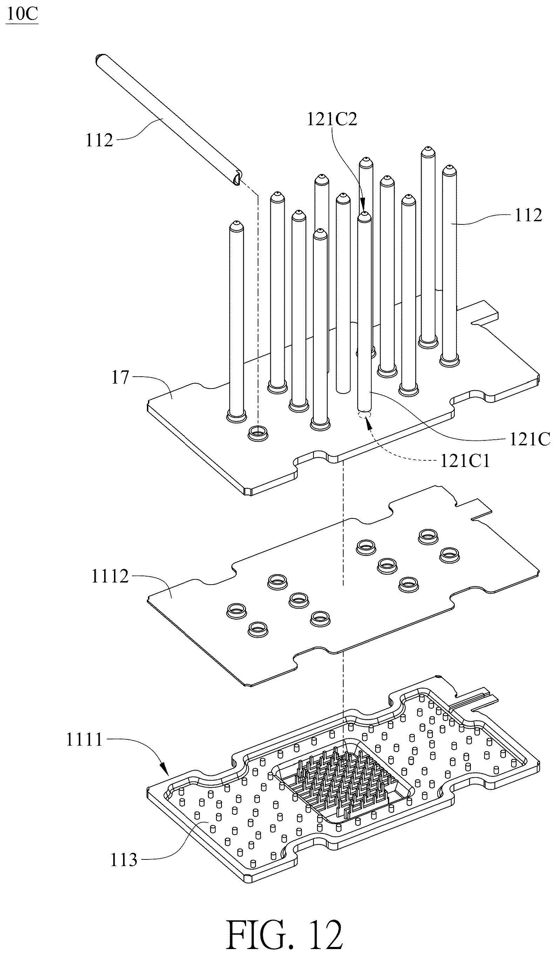

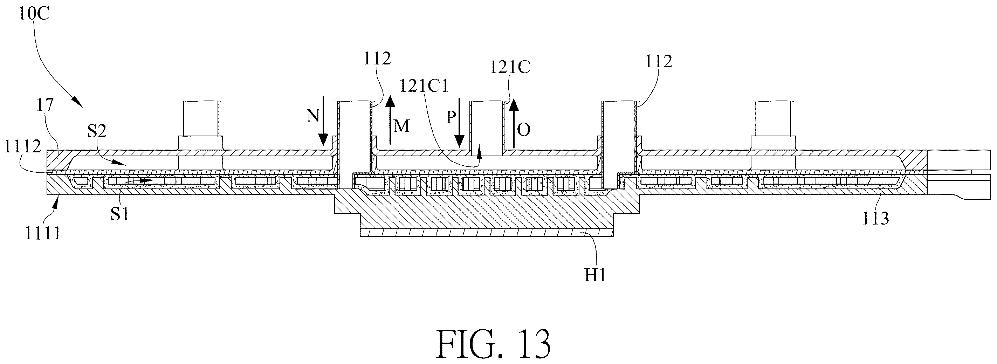

FIG. 11 is a three-dimensional view of a dual-system cooling apparatus according to a fourth embodiment of the present disclosure. FIG. 12 is a view of an exploded view of the dual-system cooling apparatus of FIG. 11. FIG. 13 is a schematic cross-sectional view of the dual-system cooling apparatus of FIG. 11.

The dual-system cooling apparatus 10C of this embodiment is similar to the dual-system cooling apparatus 10 of the first embodiment, so the following will focus on the differences between this embodiment and the first embodiment, and the similarities will not be repeated. In this embodiment, the dual-system cooling apparatus 10C includes a first heat-conducting plate 1111, a second heat-conducting plate 1112, a third heat-conducting plate 17, a plurality of heat pipes 121C and a plurality of heat pipes 112.

The first heat-conducting plate 1111 is used for thermal contact with a heat source (not shown). The second heat-conducting plate 1112 is stacked on the first heat-conducting plate 1111, and together with the first heat-conducting plate 1111, forms a first vapor chamber providing an enclosure containing a cavity S1. The cavity S1 contains a first cooling fluid (not shown). The third heat-conducting plate 17 is stacked on the second heat-conducting plate 1112, and together with the second heat-conducting plate 1112, forms a second vapor chamber providing another enclosure containing a cavity S2. The cavity S2 contains a second cooling fluid (not shown). The cavity S2 is not fluidly connected to the cavity S1. The first cooling fluid and the second cooling fluid does not mix with each other. The heat dissipation cycle of the first cooling fluid and the heat dissipation cycle of the second cooling fluid does not interfere with each other.

The heat pipes 121C are, for example, pulse heat pipes, but are not limited thereto. In other embodiments, these loop heat pipes 121C may also be, for example, thermosiphon heat pipes or capillary-structure-based heat pipes. These heat pipes 121C are, for example, integrally formed and positioned on the third heat-conducting plate 17. Each of the heat pipes 121C has an open end 121C1 and a closed end 121C2. The open end 121C1 is positioned in the cavity S2 and communicates with the cavity S2 so that the second cooling fluid circulates in a first cooling system formed by the cavity S2 and the heat pipes 121C. The heat pipes 112 protrude from the first vapor chamber and extends through the second vapor chamber positioned over the first vapor chamber. The heat pipes 112 penetrate the third heat-conducting plate 17 and the second heat-conducting plate 1112 and are connected to the cavity S1, so that the first cooling fluid circulates in a second cooling system formed by the cavity S1 and the heat pipes 112.

In this embodiment, the heat pipes 121C are integrally formed and disposed on the third heat-conducting plate 17, but the present disclosure is not limited thereto. In other embodiments, the heat pipes and the third heat-conducting plate may also be separate components, and the heat pipes are positioned on the third heat-conducting plate.

In the FIG. 13, example, when the heat generated by the heat source H1 transfers to the liquid first cooling fluid in the cavity S1 through the first heat-conducting plate 1111, the liquid first cooling fluid vaporizes and flows into the heat pipes 112 along the direction M from the cavity S1. Next, the gaseous first cooling fluid condenses in the heat pipes 112 and then flows back to the cavity S1 along a direction N. In addition, the liquid second cooling fluid in the cavity S2 will be vaporized after being heated in the cavity S2 and will flow into the loop heat pipes 121C along the direction O from the cavity S2. Then, the gaseous second cooling fluid condenses in the loop heat pipes 121C and flows back along the direction P to the cavity S2. Thus, the heat dissipation cycle for the heat source H1 can be completed.

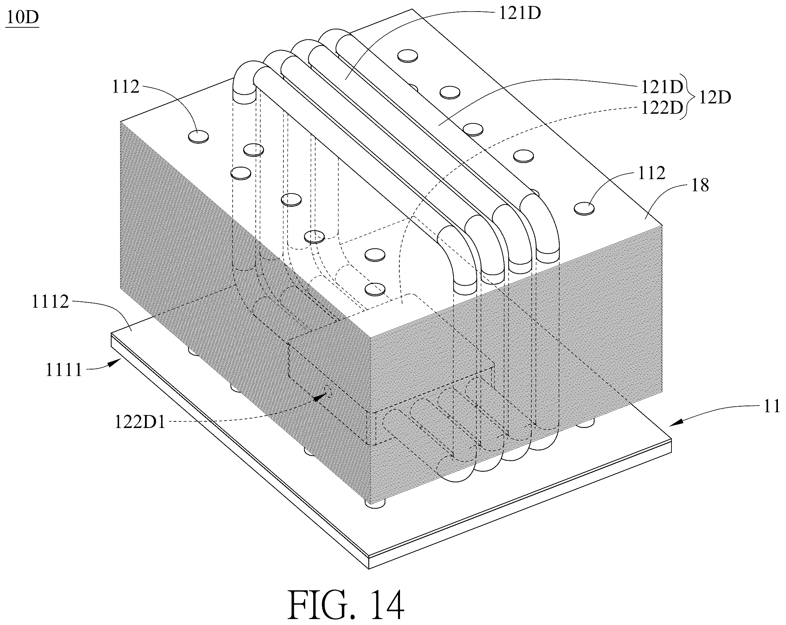

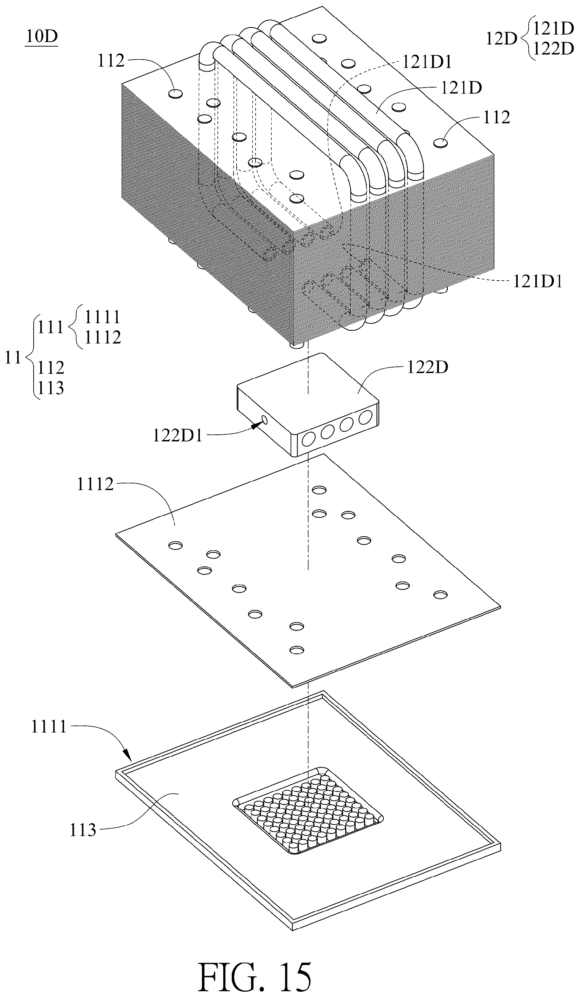

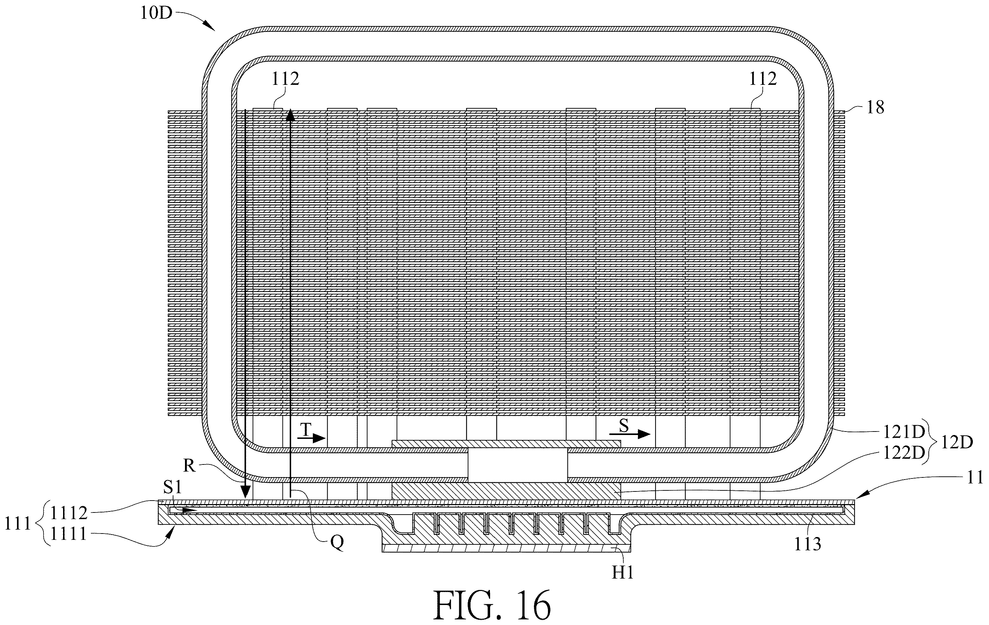

FIG. 14 is a three-dimensional view of a dual-system cooling apparatus according to a fifth embodiment of the present disclosure. FIG. 15 is a view of an exploded view of the dual-system cooling apparatus of FIG. 14. FIG. 16 is a schematic cross-sectional view of the dual-system cooling apparatus of FIG. 14.

The dual-system cooling apparatus 10D of this embodiment is similar to the dual-system cooling apparatus 10 of the first embodiment, so the following will focus on the differences between this embodiment and the first embodiment, and the similarities will not be repeated. In this embodiment, the dual-system cooling apparatus 10D includes two cooling systems: a three-dimensional vapor chamber cooling device 11 and a loop radiator 12. The dual-system cooling apparatus 10D further includes a heat dissipation fin structure 18. The three-dimensional vapor chamber cooling device 11 includes a vapor chamber 111 and a plurality of heat pipes 112.

The vapor chamber 111 includes a first heat-conducting plate 1111 and a second heat-conducting plate 1112. The first heat-conducting plate 1111 is used for thermally contacting a heat source. The second heat-conducting plate 1112 is disposed on the first heat-conducting plate 1111, so that the second heat-conducting plate 1112 and the first heat-conducting plate 1111 together enclose a cavity S1. The cavity S1 contains a first cooling fluid (not shown). The heat pipes 112 are disposed on the second heat-conducting plate 1112 and communicate with the cavity S1, so that the first cooling fluid circulates in the cavity S1 and the heat pipes 112.

The loop radiator 12D provides an enclosure containing a second cooling fluid (not shown), and includes a loop chamber 122D and a plurality of loop heat pipes 121D. The loop chamber 122D is thermally coupled to the second heat-conducting plate 1112. The loop chamber 122D is not fluidly connected to the cavity S1. The first cooling fluid and the second cooling fluid do not mix with each other. In this way, the heat dissipation cycle of the first cooling fluid and the heat dissipation cycle of the second cooling fluid do not interfere with each other. In addition, the loop chamber 122D has a through hole 122D1. The second cooling fluid may be injected into the loop chamber 122D via the through hole 122D1.

The freezing point of the first cooling fluid is, for example, higher than that of the second cooling fluid. The filling ratio of the first cooling fluid in the cavity S1 is, for example, less than that of the second cooling fluid in the loop heat pipes 121D. The loop heat pipes 121D are, for example, pulsating heat pipes, but are not limited thereto. In other embodiments, these loop heat pipes may also be, for example, thermosiphon heat pipes or capillary-structure-based heat pipes. Each of these loop heat pipes 121D has two open ends 121D1. The two open ends 121D1 are both connected to the loop chamber 122 D, so that the second cooling fluid circulates in the loop chamber 122 D and the loop heat pipes 121D. In an example, the two open ends 121D1 are connected to the loop chamber 122 D through opposing sidewalls of the loop chamber 122D, respectively.

The heat dissipation fin structure 18 is thermally coupled to the heat pipes 112 and the loop heat pipes 121D that extend through the heat dissipation fin structure 18. In this way, the heat dissipation space of the heat pipes 112 and the heat dissipation space of the loop heat pipes 121D can be further cooled through the heat dissipation fin structure 18.

In this embodiment, the heat dissipation fin structure 18 is thermally coupled to the heat pipes 112 and the loop heat pipes 121, but the present disclosure is not limited thereto. In other embodiments, the heat dissipation fin structure may also be thermally coupled only to the heat pipes or only to the loop heat pipes.

As shown in FIG. 16, in this embodiment, when the heat generated by the heat source H1 is transferred to the cooling fluid in the cavity S1 through the first heat-conducting plate 1111, the liquid first cooling fluid will be vaporized and flow from the cavity S1 along the direction Q into the heat pipes 112. Next, the gaseous first cooling fluid condenses in the heat pipes 112 and then flows back along the direction R to the cavity S1. In addition, the liquid second cooling fluid in the loop radiator 12D is vaporized after being heated in the loop chamber 122D, and flows along the direction S from the loop chamber 122D into the loop heat pipes 121D. Then, the gaseous second cooling fluid condenses in the loop heat pipes 121D and flows back along the direction T to the loop chamber 122D. Thus, the heat dissipation cycle of the cooling fluid for the heat source H1 can be completed.

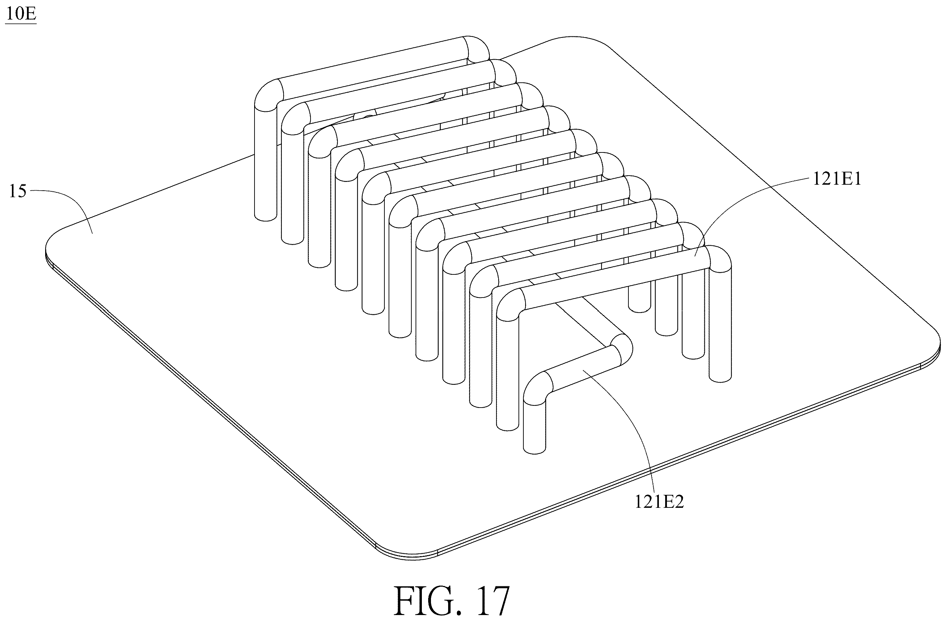

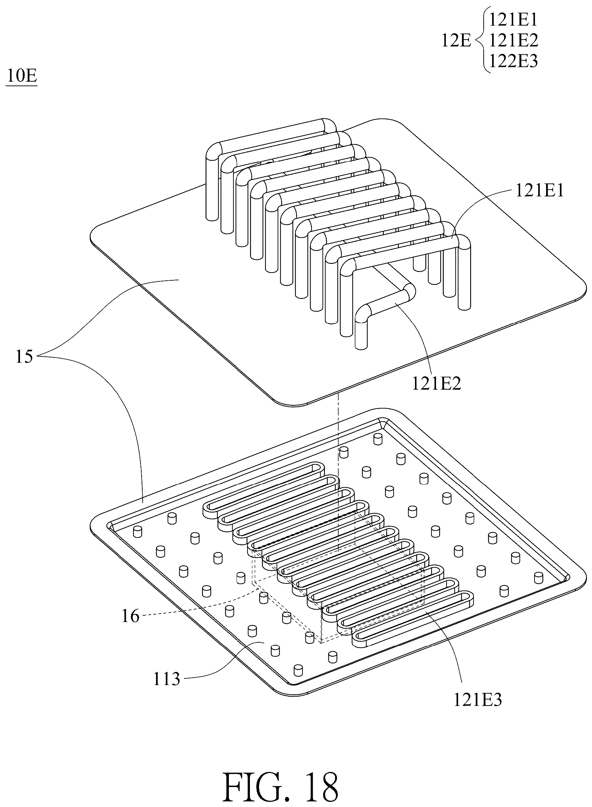

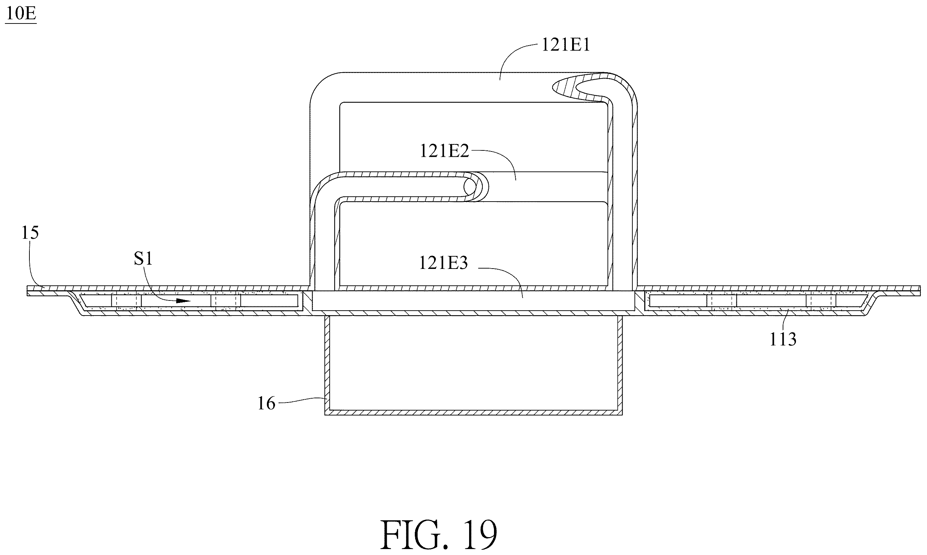

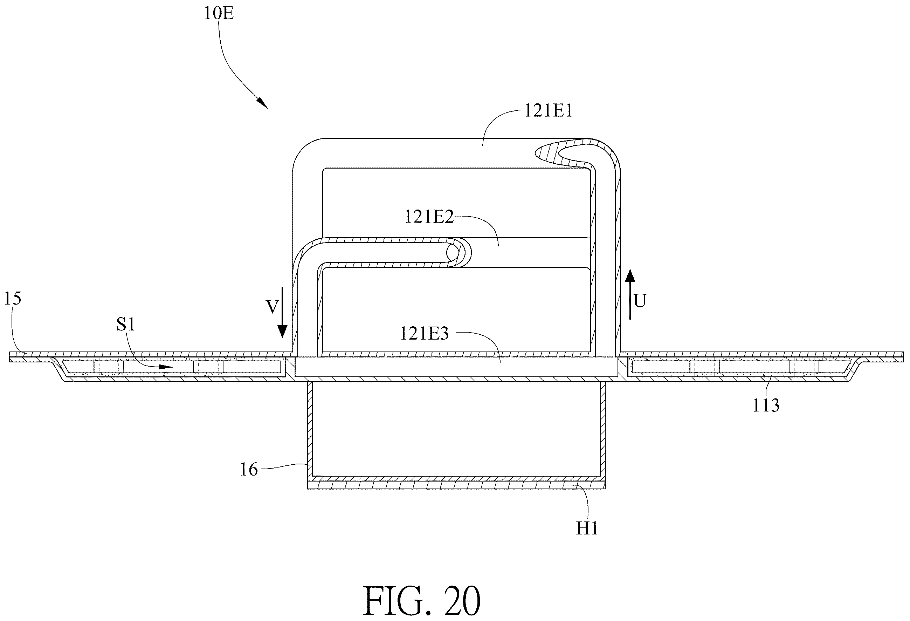

FIG. 17 is a three-dimensional view of a dual-system cooling apparatus according to a sixth embodiment of the present disclosure. FIG. 18 is a view of an exploded view of the dual-system cooling apparatus of FIG. 17. FIG. 19 is a schematic cross-sectional view of the dual-system cooling apparatus of FIG. 17. FIG. 20 is a cross-sectional view of the flow of the cooling fluid in the dual-system cooling apparatus shown in FIG. 17.

The dual-system cooling apparatus 10E of this embodiment is similar to the dual-system cooling apparatus 10 of the first embodiment. Therefore, the following will focus on the differences between this embodiment and the first embodiment, and the similarities will not be repeated. In this embodiment, the dual-system cooling apparatus 10E includes two cooling systems: a vapor chamber cooling device 15 and a loop heat pipe 12E. The dual-system cooling apparatus 10E further includes a heat-absorbing cavity 16.

In an example, the vapor chamber cooling device 15 includes a vapor chamber 15 that defines a cavity S1. The cavity S1 contains a first cooling fluid (not shown). The heat-absorbing cavity 16 is thermally coupled to one side of the vapor chamber 15. The vapor chamber 15 is not fluidly connected to the heat-absorbing cavity 16. The heat-absorbing cavity 16 is used for thermally contacting the heat source, so that the heat generated by the heat source is transferred to the vapor chamber 15 through the heat-absorbing cavity 16.

The loop heat pipe 12E is, for example, a pulsating heat pipe, but is not limited thereto. In other embodiments, the loop heat pipe may be, for example, a thermosiphon heat pipe or a capillary-structure-based heat pipe. The loop heat pipe 12E is partially embedded in the vapor chamber 15. The loop heat pipe 12E provides an enclosure containing a second cooling fluid (not shown). The loop heat pipe 12E is not fluidly connected to the cavity S1, so that the loop heat pipe 12E form a circulation channel (closed-loop channel). The first cooling fluid and the second cooling fluid do not mix with each other. The heat dissipation cycle of the first cooling fluid and the heat dissipation cycle of the second cooling fluid do not interfere with each other.

In the FIG. 18 example, the loop heat pipe 12E includes a sequence of upper loop portions 121E1, a connection portion 121E2, and a sequence of bottom loop portions 121E3. The bottom loop portions 121E3 are embedded in the vapor chamber 15 and arranged in parallel with each other. Each bottom loop portion 121E3 is positioned between two opposing plates of the vapor chamber 15. Each bottom loop portion 121E3 also serves as a support structure of the vapor chamber 15. Each upper loop portion 121E1 is fluidly connected to two neighboring bottom loop portions. The connection portion 121E2 connects the first bottom loop portion 121E3 to the last bottom loop portion 121E3 in the sequence of bottom loop portions 121E3.

Accordingly, the loop heat pipe 12E forms a closed-loop channel. The closed-loop channel includes a first portion and a second portion. The first portion includes a sequence of similarly-structured sections connected sequentially. Each such section has a first sub-section contained in the respective bottom loop portion 121E3 and a second sub-section contained in the respective upper loop portion 121E1. The second sub-section has a first open end connecting to the first sub-section of the same similarly-structured section and a second open end connecting to the first sub-section of the neighboring similarly-structured section. The second portion of the closed-loop channel is contained within the connection portion 121E2. The second portion of the closed-loop channel connects two ends of the first portion of the closed-loop channel.

The heat-absorbing cavity 16 is thermally coupled to one side of the vapor chamber 15 but is not fluidly connected to the vapor chamber 15. Such a structural design can also be applied to the first through fifth embodiments described above.

As shown in FIG. 20, in this embodiment, the cavity S1 of the vapor chamber is separate from the closed-loop channel of the loop heat pipe 12E. When the heat generated by the heat source H1 is transferred to the first liquid cooling fluid in the cavity S1 through the heat-absorbing cavity 16, the liquid first cooling fluid undergoes a heat dissipation cycle involving vaporization and condensation. When the heat generated by the heat source H1 is transferred to the liquid second cooling fluid in the closed-loop channel through the heat-absorbing cavity 16, the liquid second cooling fluid is vaporized and flows in the direction U away from the heat source area above the heat-absorbing cavity. Next, the gaseous cooling fluid condenses in the loop heat pipe 12E and then flows back in the direction V to the heat source area. In this way, the heat dissipation cycle of the cooling fluid for the heat source H1 can be completed.

While aspects of the present disclosure have been described in conjunction with the specific embodiments thereof that are proposed as examples, alternatives, modifications, and variations to the examples may be made. Accordingly, embodiments as set forth herein are intended to be illustrative and not limiting. There are changes that may be made without departing from the scope of the claims set forth below.

## Claims

1. A dual-system cooling apparatus (10A, 10B, 10C, 10D, 10E), comprising:
a first cooling system having a first enclosure that encloses a first cavity (S1); and
a second cooling system having a second enclosure that encloses a second cavity (S2) and has a capillary structure on an inner surface of the second enclosure,
wherein the first enclosure is positioned over the second enclosure, and a first working fluid of the first cooling system is different from a second working fluid of the second cooling system.

2. The dual-system cooling apparatus (10A, 10B, 10C, 10D, 10E) of claim 1,
wherein a first freezing point of the first working fluid of the first cooling system is lower than a second freezing point of the second working fluid of the second cooling system.

3. The dual-system cooling apparatus (10A, 10B, 10C, 10D, 10E ) of claim 1 or 2, wherein the second cooling system is a vapor chamber cooling device (11A), and the first cooling system includes a capillary-structure-based heat pipe (121A), a thermosiphon, or a pulsating heat pipe.

4. The dual-system cooling apparatus (10A, 10B, 10C, 10D, 10E) of one of claims 1 to 3, wherein the second cooling system is a vapor chamber cooling device (11A) that includes:
a vapor chamber (111A) formed by a first plate (1111A) and a second plate (1112A) opposing the first plate (1111A); and
a first column structure (13) and a second column structure (14) within the vapor chamber (111A), the first column structure (13) and the second column structure (14) extending from the first plate (1111A) to the second plate (1112A), the first column structure (13) being positioned at a heat source area of the vapor chamber (111A), the second column structure (14) being positioned outside the heat source area.

5. The dual-system cooling apparatus (10A) of claim 1, wherein the second cooling system is a vapor chamber cooling device (11A) having a vapor chamber (111A) formed by two opposing plates (1111A, 1112A), and the first cooling system is a loop heat pipe (121A) with a closed-loop channel, a section of the loop heat pipe (121A) being in contact with one of the two opposing plates (1111A, 1112A).

6. The dual-system cooling apparatus (10A) of claim 5, wherein the section of the loop heat pipe (121A) passes through the vapor chamber (111A).

7. The dual-system cooling apparatus (10A) of claim 5 or 6, wherein the loop heat pipe (121A) includes a capillary-structure-based heat pipe, a thermosiphon, or a pulsating heat pipe.

8. The dual-system cooling apparatus (10B) of claim 1, wherein the second cooling system is a vapor chamber cooling device (11) having a vapor chamber (111) formed by two opposing plates (1111, 1112), and
the first cooling system includes:
a chamber (122B) positioned in contact with one of the two opposing plates (1111, 1112) and having two openings in a sidewall of the chamber, and
a heat pipe (121B) having two open ends (121B1) in connection with the chamber (122B) via the two openings.

9. The dual-system cooling apparatus (10B) of claim 1, wherein the second cooling system is a vapor chamber cooling device (11) having a vapor chamber (111) formed by two opposing plates (1111, 1112), and
the first cooling system includes:
a first chamber (C1) positioned over a second chamber (C2) that is positioned on one of the two opposing plates (1111, 1112),
a first heat pipe (121B) having a first open end and a second open end, and
a second heat pipe (121B) having a third open end and a fourth open end,
wherein the first open end and the third open end are fluidly connected with the first chamber (C1), and the second open end and the fourth open end are fluidly connected with the second chamber (C2).

10. The dual-system cooling apparatus (10B) of claim 9, wherein the first heat pipe (121B) or the second heat pipe (121B) includes a capillary-structure-based heat pipe, a thermosiphon, or a pulsating heat pipe.

11. The dual-system cooling apparatus (10C) of claim 1, wherein the first cooling system is a first vapor chamber cooling device having a first vapor chamber, and the second cooling system is a second vapor chamber cooling device having a second vapor chamber, wherein the first vapor chamber is positioned over the second vapor chamber, and the second vapor chamber cooling device has a heat pipe (112) protruding from the second vapor chamber and extends through the first vapor chamber positioned over the second vapor chamber.

12. The dual-system cooling apparatus (10D) of claim 1, wherein
the first cooling system includes a first vapor chamber (122D) and a first heat pipe (121D) with two open ends connected to two opposing sidewalls of the first vapor chamber (122D), and
the second cooling system is a vapor chamber cooling device (11) that includes a second vapor chamber (111) and a second heat pipe (112) protruding from the second vapor chamber (111), the second heat pipe (112) having a closed end and an open end connecting to the second vapor chamber (111),
wherein the first vapor chamber (122D) is positioned in contact with the second vapor chamber (111), and the first heat pipe (121D) and the second heat pipe (112) extend through a fin structure (18).

13. The dual-system cooling apparatus (10D) of claim 12, wherein the first heat pipe (121D) includes a capillary-structure-based heat pipe, a thermosiphon, or a pulsating heat pipe.

14. The dual-system cooling apparatus (10E) of claim 1, wherein the second cooling system is a vapor chamber cooling system having a vapor chamber (15), and the first cooling system is a loop heat pipe (12E) with a closed-loop channel that includes a first portion, the first portion including a sequence of similarly-structured sections connected sequentially, each such section having a first sub-section (121E3) contained in the vapor chamber and a second sub-section (121E1) formed outside the vapor chamber, the second sub-section having a first open end connecting to the first sub-section of the same similarly-structured section and a second open end connecting to the first sub-section of the neighboring similarly-structured section.

15. The dual-system cooling apparatus (10E) of claim 14, wherein the closed loop channel includes a second portion (121E) formed outside the vapor chamber (15), the second portion connecting a first end of the first portion to a second end of the first portion.

16. The dual-system cooling apparatus (10E) of claim 14, wherein the first sub-sections (121E3) of the sequence of similarly-structured sections are arranged in parallel with each other in the vapor chamber (15).

17. The dual-system cooling apparatus (10E) of claim 14, wherein the loop heat pipe (12E) includes a capillary-structure-based heat pipe, a thermosiphon, or a pulsating heat pipe.

18. A three-dimensional vapor chamber cooling apparatus (11), comprising:
a vapor chamber (111) formed by a first plate (1111) and a second plate (1112) opposing the first plate (1111), the vapor chamber (111) including a heat source area on an inner surface of the first plate (1111);
a first heat pipe (112) protruding from and on top of the second plate (1112), the first heat pipe (112) having a closed end and an open end connecting to the vapor chamber (111) at a first portion of the second plate (1112) that opposes an area on the inner surface of the first plate (1111) outside the heat source area; and
a second heat pipe (121) formed outside of the vapor chamber (111) and having two open ends connecting to the vapor chamber (111) through the second plate (1112) at a second portion of the second plate (1112) opposing the heat source area on the inner surface of the second plate (1111).

19. The three-dimensional vapor chamber cooling apparatus (11) of claim 18, wherein the second heat pipe (121) includes a capillary-structure-based heat pipe, a thermosiphon, or a pulsating heat pipe.

20. The three-dimensional vapor chamber cooling apparatus (11) of claim 18, further comprising:
a first column structure (13) and a second column structure (14) within the vapor chamber (111), the first column structure (13) and the second column structure (14) extending from the first plate (1111) to the second plate (1112) opposing the first plate (1111), the first column structure (13) being positioned at the heat source area, the second column structure (14) being positioned outside the heat source area, the first column structure (13) having a larger cross-sectional area than the second column structure (14).
